# EUROPÄISCHE PATENTSCHRIFT

(11) **EP 2 247 504 B1**
(45) Veröffentlichungstag und Bekanntmachung des Hinweises auf die Patenterteilung: **01.01.2014**
(21) Anmeldenummer: 09714564.3
(22) Anmeldetag: 12.02.2009
(51) Int. Cl.: B64D 43/00

(54) **MODULARER GERÄTETRÄGER**
MODULAR DEVICE HOLDER
SUPPORT D'APPAREILS MODULAIRE

(30) Priorität: 25.02.2008 DE 102008011026; 25.02.2008 US 66969
(43) Veröffentlichungstag der Anmeldung: 10.11.2010
(73) Patentinhaber: Airbus Operations GmbH, 21129 Hamburg (DE)
(72) Erfinder: JÄGER, Hartwig, 21635 Jork (DE); ROHLFS, Gerd, 21635 Jork (DE); BARTELS, Benjamin, 22305 Hamburg (DE); LÜDEMANN, Olaf, 27383 Scheessel (DE)
(74) Vertreter: Kopf, Korbinian Paul
(86) Internationale Anmeldenummer: PCT/EP2009/051624
(87) Internationale Veröffentlichungsnummer: WO 2009/106430

(56) Entgegenhaltungen:
- EP-B1- 1 380 196
- DE-A1- 10 333 353
- US-A- 2 938 686
- US-A- 4 776 903
- US-A1- 2003 036 347
- US-A1- 2007 139 868

## Beschreibung

Die Erfindung betrifft einen Geräteträger zum Haltern von Geräten in einem Fahrzeug.

### TECHNOLOGISCHER HINTERGRUND DER ERFINDUNG

In modernen Fahrzeugen, wie beispielsweise in Passagierflugzeugen, werden vermehrt technische Geräte eingebaut, die nicht zur eigentlichen Funktionsfähigkeit des Fahrzeugs beitragen, sondern andere Aufgaben erfüllen. Dies können beispielsweise Geräte zur Bordunterhaltung oder zur Kommunikation sein. Solche Geräte werden üblicherweise in designierte Geräteträger eingebaut, welche an speziellen bevorzugten Einbauorten innerhalb des Fahrzeugs angeordnet werden. Beispielsweise können sich solche Einbauorte in Passagierflugzeugen unterhalb des Cockpits befinden, innerhalb von Über-Kopf-Staufächern oder an anderen geeigneten Orten. Die vorangehend bezeichneten Geräte, die auch "kommerzielles Equipment" genannt werden, sind im Falle von Passagierflugzeugen meist örtlich oder zumindest von der Versorgung von avionischen Geräten separiert, die zum sicheren Betrieb des Flugzeugs notwendig sind. Üblicherweise besteht ein herkömmlicher Geräteträger aus einem geschlossenen und bevorzugt in SandwichBauweise mit Metallverstärkungen aufgebauten Gehäuse, das feuer- und rauchdicht ist und mit Streben hängend oder stehend an der Flugzeugstruktur befestigt wird. Es existieren ferner auch Geräteträger in offener Bauweise, die selbsttragend ausgeführt sind. Geräteträger werden des Weiteren über standardisierte Schnittstellen insbesondere mit der Elektrik zum Versorgen der Geräte und einem flugzeugseitigen Kühlsystem zum Abführen von Abwärme aus den Geräten verbunden. Im Inneren des Geräteträgers ist es möglich, kundenspezifische Anpassungen vorzunehmen.

In US-A-2 938 686 wird eine Anordnung zum Unterbringen elektronischer Geräte in einem Flugzeug gezeigt, die insbesondere darauf gerichtet ist, die Gerätedichte zu erhöhen, die Effizienz der Kühlung durch einen zentralen Kühlluftanschluss zu maximieren, die Wartung zu erleichtern und das Gewicht zu verringern.

DE 103 33 353 A1 offenbart einen Geräteträger zur Aufnahme und Kühlung von elektronischen Geräten insbesondere in einem Flugzeug.

### ZUSAMMENFASSUNG DER ERFINDUNG

Nachteilig an bisherigen Lösungen bei Geräteträgern in Flugzeugen ist, dass die bisherigen Geräteträger nur für bestimmte und vom Typ bei der Ausstattung des Flugzeugs vorbestimmter Geräte individuell entwickelt werden, für andere, nachträglich einzubauende Geräte jedoch nicht unbedingt geeignet sind. Wird es erforderlich, neuartige oder anfänglich nicht vorgesehenes Gerät in einen vorhandenen Geräteträger zu integrieren, hat dies zur Folge, dass beispielsweise relativ kleine Geräte den zur Verfügung stehenden Bauraum blockieren, gleichzeitig aber den Geräteträger nicht vollständig ausnutzen. Demnach wird ein überdimensionierter Geräteträger mit einem größeren als notwendigen Gewicht über eine lange Laufzeit mit dem Flugzeug mittransportiert. Ist jedoch das nachträglich zu integrierende Gerät zu groß für den vorhandenen Geräteträger, muss ein neuer Bauraum innerhalb des Flugzeugs gefunden und untersucht werden, um einen für das zu integrierende Gerät passenden Geräteträger zu entwickeln. Alles in allem können übliche Geräteträger nicht flexibel zur Aufnahme von Geräten unterschiedlicher Bauformen und -größen verwendet werden.

Die Aufgabe der Erfindung ist daher, einen Geräteträger vorzuschlagen, der zum Integrieren verschiedenster Geräte in den Geräteträger eingerichtet ist, um gleichzeitig den Entwicklungsaufwand zu reduzieren, Änderungen an der Struktur zu vermeiden und den im Flugzeug vorhandenen Bauraum möglichst effektiv zu nutzen.

Die Aufgabe wird durch einen Geräteträger nach Anspruch 1 gelöst, der mindestens ein äußeres Gestell und mindestens ein inneres Gestell aufweist, wobei das äußere Gestell an der Struktur des Fahrzeugs lagerbar ist und das innere Gestell an oder in dem äußeren Gestell anbringbar ist und Mittel zum Bilden von einem oder mehreren Fächern variabler Größe aufweist. Diese Mittel können flächige, rahmenartige, linienförmige oder punktförmige Elemente sein, die etwa in festgelegten Raststufen oder stufenlos innerhalb des inneren Gestells verschiebbar befestigt werden. Das innere Gestell besteht bevorzugt aus einem in das äußere Gestell einschiebbaren Metallträger.

Der erfindungsgemäße Geräteträger kann modular aufgebaut und damit aus standardisierten Bauelementen oder Baugruppen leicht hergestellt werden. Ein äußeres Gestell kann innerhalb des zur Verfügung stehenden Volumens des Fahrzeugs angebracht bzw. gelagert werden, um einen voll nutzbaren, standardisierten Bauraum bereitzustellen, der eine Bauraumuntersuchung und Identifizieren von mechanischen Anbindungspunkten bei Nachrüstung von Geräten überflüssig macht. Durch das innere Gestell, in dem mehrere Fächer verschiedenster Größen bereitgestellt werden können, wird das äußere Gestell zu einem vollständigen Geräteträger ergänzt. Bevorzugt weisen die Fächer Einsätze (sogenannte "Trays") für die zu integrierenden Geräte auf, während die Rückwand ("Backplane") des inneren Gestells Anbindungspunkte und Schnittstellen, insbesondere zur elektrischen Versorgung und zur Anbindung an Datennetze oder Datenbusse, aufweist. Der Geräteträger ist bevorzugt so ausgelegt, dass das äußere Gestell die fahrzeugseitigen und geräteträgerseitigen Lasten vollständig aufnehmen kann. Bevorzugt wird das äußere Gestell in unterschiedlichen Standardbreiten vorgehalten, um verschiedenste Konfigurationen für einzubauende Geräte abdecken zu können und durch Anpassung an notwendigen Bauraum möglichst viel Gewicht einzusparen. Das innere Gestell sollte auf die Anforderungen des einzubauenden Geräts anpassbar sein und es sollte die Möglichkeit gegeben sein, die Geräte im Inneren des inneren Gestells nach Kundenwunsch einzubauen. Ferner ist es bei einem erfindungsgemäßen Geräteträger möglich, verschiedene äußere Gestelle in Modulbauweise miteinander zu kombinieren, so dass für nachträglich zu ergänzende Geräte leicht neuer standardisierter Bauraum bereitgestellt werden kann, der durch innere Gestelle in optimierter Weise genutzt wird.

Der erfindungsgemäße Geräteträger hat mehrere Vorteile gegenüber Geräteträgern aus dem Stand der Technik. Zunächst wird der Entwicklungsaufwand für die Integration unterschiedlichster Geräte verkürzt. Dies bedeutet, dass ein Geräteträger in der Lage ist, verschiedenste einzubauende Geräte flexibel aufzunehmen. Weiterhin ist durch den modularen Aufbau die Möglichkeit gegeben, bereits ohne vorherige umfangreiche Auslegung standardisierte Schnittstellen zur Kühlung, zur elektrischen Versorgung und für die mechanische Lagerung des Geräteträgers zur Verfügung stellen zu können. Weiterhin ist ein erfindungsgemäßer Geräteträger nachträglich relativ leicht zu erweitern, so dass eine gewisse Flexibilität für zusätzliche Geräte innerhalb des Fahrzeugs gegeben ist. Innerhalb des Bauraums des Fahrzeugs sind keine zusätzlichen Bauraumuntersuchungen notwendig, da innerhalb des äußeren Gestells ein standardisierter Bauraum zur Verfügung steht.

Die Aufgabe wird ferner durch eine Verwendung eines erfindungsgemäßen Geräteträgers in einem Flugzeug gelöst, sowie durch ein Flugzeug mit einem erfindungsgemäßen Geräteträger.

### KURZE BESCHREIBUNG DER ZEICHNUNGEN

Die Erfindung wird nachfolgend anhand von Figuren näher erläutert. In den Figuren stehen gleiche Bezugszeichen für gleiche Objekte. Es zeigen:
- Fig. 1:: eine Gesamtübersicht über einen erfindungsgemäßen Geräteträger im eingebauten Zustand;
- Fig. 2:: eine Übersicht über das äußere Rahmengestell, das innere Rahmengestell und eines zusammengestellten erfindungsgemäßen Geräteträgers;
- Fig. 3:: eine Übersicht über die Erweiterbarkeit eines erfindungsgemäßen Geräteträgers;
- Fig. 4a: bis c: einen erfindungsgemäßer Geräteträger im eingebauten Zustand mit verschiedenen Ausbaustufen; und
- Fig. 5:: eine beispielhafte Einbauposition eines erfindungsgemäßen Geräteträgers.

### DETAILLIERTE BESCHREIBUNG DER AUSFÜHRUNGSBEISPIELE

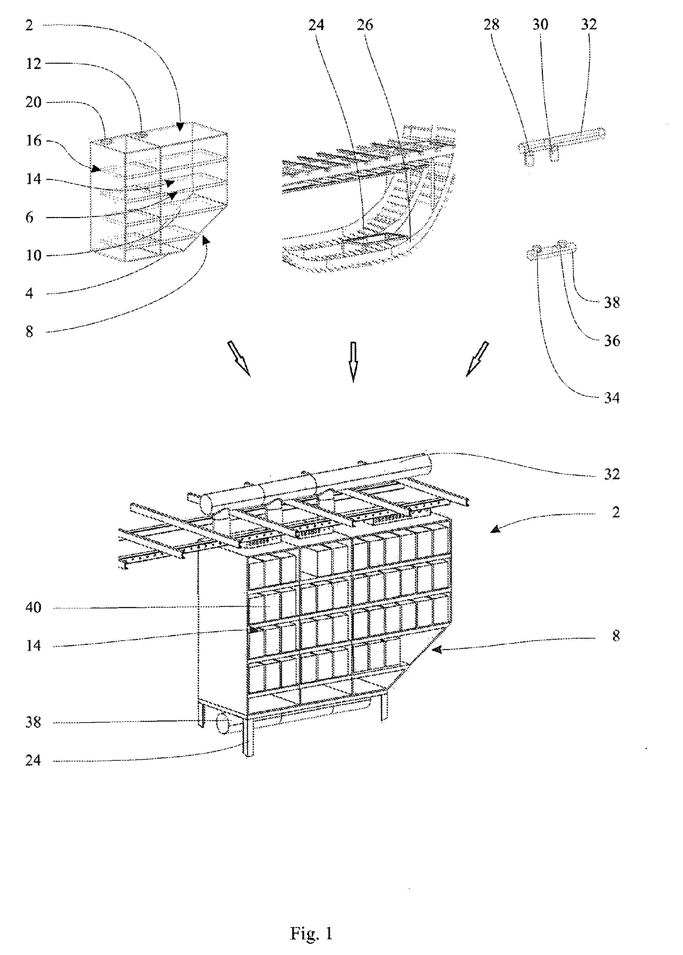

Der grundsätzliche Aufbau eines erfindungsgemäßen Geräteträgers kann der Fig. 1 entnommen werden. Der erfindungsgemäße Geräteträger 2 weist ein äußeres Gestell 4 auf, in dem ein inneres Gestell 6 anbringbar ist. Die Gestelle 4 und 6 sind exemplarisch als Rahmengestelle ausgeführt, die eine zumindest teilweise verkleidete Rahmenstruktur aufweisen. Beispielhaft ist das äußere Rahmengestell 4 - wie in Fig. 1 dargestellt - an einer unteren Ecke 8 angeschrägt, so dass es beispielsweise seitlich in den Frachtraum eines Flugzeugs einbaubar ist, der abgeschrägte untere Wandbereiche aufweist. Dadurch kann das äußere Rahmengestell 4 den in einem Frachtraum angebotenen Raum optimal nutzen und gleichzeitig in seinem Inneren mittels des inneren Rahmengestells 6 standardisierte oder individuell zusammengestellte Aufnahmefächer 14 zur Aufnahme von zu integrierenden Geräten bieten.

Die betreffenden Geräte, welche beispielsweise zur Bewältigung von datenverarbeitenden Anwendungen, wie etwa zur Bordunterhaltung ("In-Flight-Entertainment") oder zur Kommunikation dienen, produzieren Abwärme auf engem Raum und weisen demnach einen teilweise relativ hohen Kühlbedarf auf. Zur Deckung dieses Kühlbedarfs weist das äußere Rahmengestell 4 mindestens einen exemplarisch an der Oberseite dargestellten Kühllufteingang 12 des Rahmengestells 4 auf, durch den beispielsweise von einem zentralen Kühlsystem bereitgestellte Kühlluft eingeleitet werden kann, die nach Kühlung der Geräte durch einen in Fig. 1 nicht dargestellten Kühlluftauslass den Geräteträger 2 wieder verlassen kann. Die Kühlluft kann auch durch andere Öffnungen im Geräteträger 2, z.B. an der Vorderseite oder der Unterseite des Geräteträgers, eingesogen/eingelassen werden.

Das innere Rahmengestell 6 weist in der Darstellung aus Fig. 1 beispielhaft mehrere Fächer 14 auf, in die die Geräte einstellbar und befestigbar sind. Bevorzugt weisen die Fächer 14 Einsätze ("Trays") für die Geräte bzw. die Rückwand ("Backplane") des inneren Rahmengestells 6 alle zur Verkabelung und Versorgung der Geräte notwendigen Schnittstellen auf, insbesondere zur elektrischen Versorgung und zur Anbindung an Datennetze oder Datenbusse. Zwar ist die Darstellung aus Fig. 1 als Art Regalsystem dargestellt, das etwa flächige bzw. rahmenförmige Elemente 10 zum Bilden von Fächern variabler Größe vorsieht. Andererseits können auch linienförmige oder punktförmige Elemente verwendet werden, die zum Haltern von Geräten geeignet sind. Neben den aufgeführten Mitteln sind auch alle anderen geeigneten Arten von Fachbegrenzungsmitteln oder Fachaufteilungsformen denkbar. Fachbegrenzungsmittel 10 können dabei mit Rastmitteln, mechanischen Anbindungspunkten oder Führungen am inneren Gestell 6 gehaltert werden, wobei die Rastmittel, Anbindungspunkte oder Führungen an einem äußeren Rahmen des inneren Gestells 6 bereitgestellt werden könnten.

Ein erfindungsgemäßer Geräteträger 2 kann mittels verschiedener zusätzlicher Module 16 erweitert werden, wenn dies erforderlich ist. Beispielsweise könnte der erfindungsgemäße Geräteträger 2 mit seiner speziellen und an den Frachtraum eines Flugzeugs angepassten Form durch einen einfachen, quaderförmigen Modulanbau 16 in seiner Breite vergrößert werden. Der Modulanbau 16 weist ebenfalls ein äußeres Rahmengestell 18 auf, welches an einer Seite ebenfalls mindestens einen Kühllufteingang 20 aufweist. Auch bei einem Modulanbau 16 können Kühllufteinlässe an anderen Stellen vorgesehen werden, etwa an der Vorderseite oder der Unterseite. Innerhalb des äußeren Rahmengestells 18 befindet sich ein inneres Rahmengestell 22, welches in dem gewählten Beispiel die gleiche Aufteilung aufweist wie das innere Rahmengestell 6 des ursprünglichen und nicht erweiterten Geräteträgers 2.

Die Integration des erfindungsgemäßen Geräteträgers 2 in eine Fahrzeugstruktur - hier beispielsweise die Flugzeugstruktur - könnte exemplarisch im Frachtraum erfolgen, wie ebenfalls in Fig. 1 dargestellt. Zur Integration könnte etwa ein Träger 24 auf dem Frachtraumfußboden 26 angebracht sein, auf den der erfindungsgemäße Geräteträger 2 aufgeschraubt oder anders befestigt werden könnte.

Die Kühllufteinlässe 12 und 20, die Luft - hier beispielhaft dargestellt - aus Kühlluftauslässen 28 und 30 beziehen, sind im eingebauten und bestückten Zustand des Geräteträgers 2 an einer Kühlluftleitung 32 angeordnet. Die Kühlluftauslässe, die in Fig. 1 nicht dargestellt sind, sind mit Abluftöffnungen 34 und 36 eines Abluftrohrs 38 verbunden, die die erwärmte Kühlluft von dem Geräteträger 2 abtransportieren. Ebenfalls in der Fig. 1 dargestellt ist ein kompletter Zusammenbau aus einem erfindungsgemäßen Geräteträger 2, der mit Kühlluftauslässen 28 und 30 verbunden ist und auf dem Träger 24 auf dem Frachtraumfußboden 26 montiert ist. In dem erfindungsgemäßen Geräteträger 2 sind verschiedene Geräte 40 integriert, auf deren Abmessungen die Fächer 14 abgestimmt sind, so dass der innerhalb des Geräteträgers zur Verfügung gestellte Bauraum nahezu optimal ausgenutzt wird. Innerhalb des Geräteträgers 2 werden bis auf die besonderen geometrischen Stellen mit schrägen Seitenwänden kaum ungenutzte Lücken gelassen.

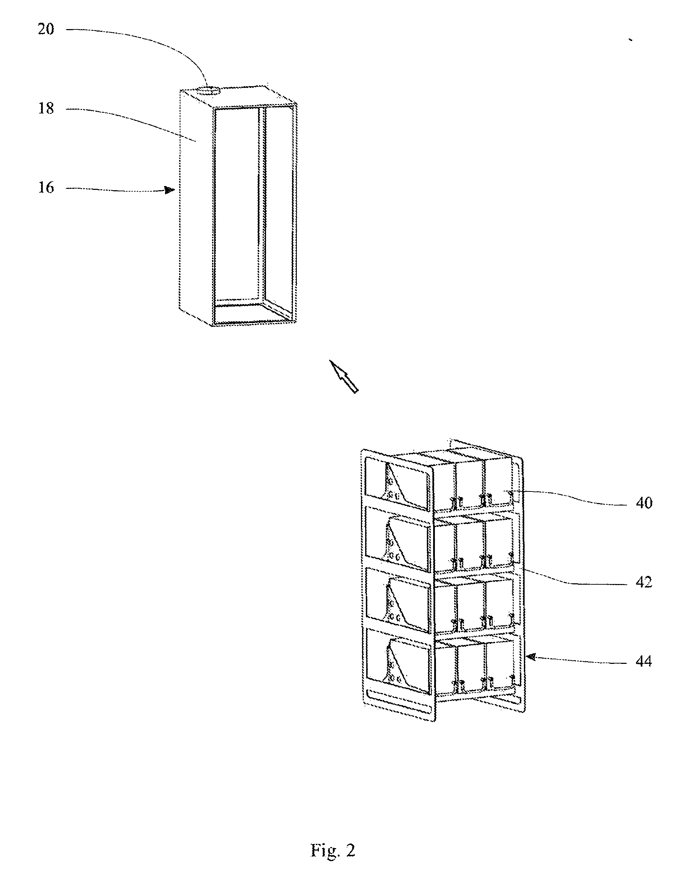

Ein Ausführungsbeispiel des erfindungsgemäßen Geräteträgers 2 anhand der geometrisch einfachsten Darstellung eines Modulanbaus 16 wird in Fig. 2 gezeigt. Der Modulanbau 16 weist das äußere Rahmengestell 18 auf, das im Wesentlichen eine Quaderform besitzt und wie ein äußeres Rahmengestell 4 aus einem einen Wabenkern aufweisenden Werkstoff aufgebaut sein kann, der eine relativ geringes spezifisches Gewicht und dennoch eine hohe Festigkeit aufweist. An der Oberseite ist der Kühllufteinlass 20 zu finden. In dieses äußere Rahmengestell 18 kann ein inneres Rahmengestell 42 integriert werden, das beispielhaft 4 Regalreihen 44 aufweist, in die jeweils drei Geräte 40 integriert werden können. Das innere Rahmengestell 42 stellt einen individuellen Geräteträger dar, der auch als "Subrack" bezeichnet werden kann. Dieser individuelle Geräteträger 42 kann für den Betreiber des betreffenden Fahrzeugs bzw. Flugzeugs individuell ausgerüstet werden und in das standardisierte Abmessungen aufweisende äußere Rahmengestell 18 eingeschoben werden. Somit kann der zur Verfügung gestellte Bauraum individuell an die Anzahl der notwendigen Geräte 40 angepasst werden, indem verschiedene Anbaumodule in Form von äußeren Rahmengestellen 18 zur Verfügung gestellt werden, welche an andere, benachbarte äußere Rahmengestelle 4 anbaubar sind.

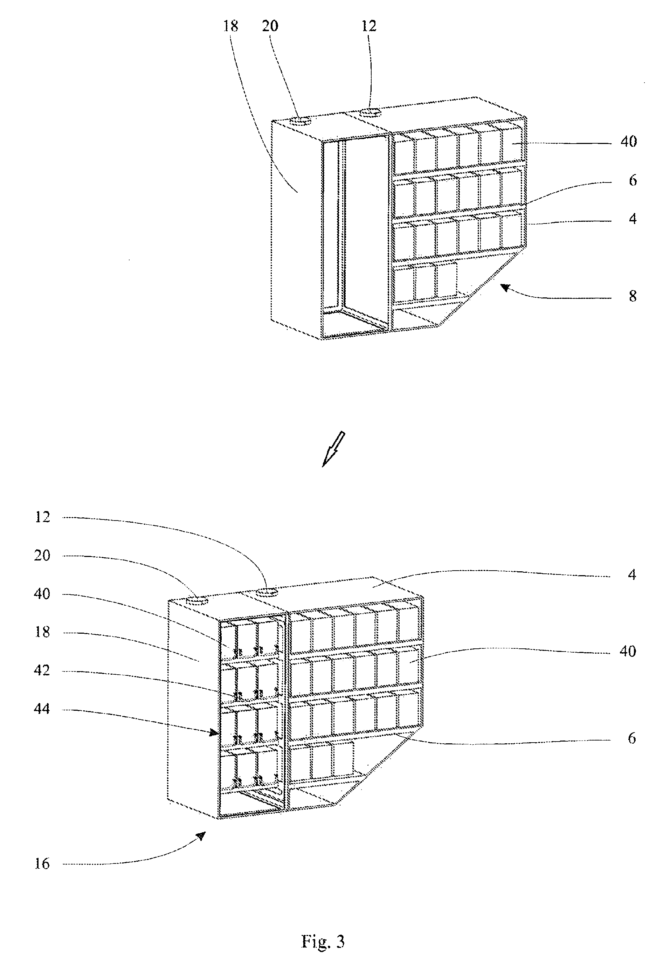

In Fig. 3 wird dieser Vorgang schematisch gezeigt, bei dem eine als Grundmodul fungierende Kombination aus einem äußeren Rahmengestell 4 und einem inneren Rahmengestell 6 mit mehreren eingebrachten Geräten 40 bereits in den zur Verfügung gestellten Bauraum des Flugzeugs eingebaut ist. Werden noch mehr Geräte 40 als ursprünglich vorgesehen an Bord des Flugzeugs benötigt, lässt sich ein weiteres äußeres Rahmengestell 18 leicht an das ursprünglich eingebaute äußere Rahmengestell 4 anbringen, um so den standardisierten Bauraum zur Aufnahme eines individuellen Geräteträgers in Form eines inneren Rahmengestells 42 zu vergrößern. Auf der linken oberen Seite in Fig. 3 ist ein leeres Anbaumodul 16 gezeigt, das auf der rechten unteren Seite in Fig. 3 mit einem individuellen Geräteträger 42 ausgerüstet ist. Die individuellen Anpassarbeiten würden sich in diesem Falle darauf beschränken, die Zu- und Abluftleitungen für die Kühlluft, von denen die Kühlluftzufuhröffnungen 12 und 20 ersichtlich sind, mit Kühlluftleitungen verbunden werden müssen. Ebenso notwendig ist das Bestücken des Anbaumoduls 16 mit notwendiger elektrischer Verkabelung. Da elektrische Verkabelung und Rohrleitungen jedoch weitaus flexibler zu handhaben sind als das Schaffen individueller Bauräume, die großen mechanischen Anforderungen gewachsen sein müssen, stellen diese individuellen Anpassarbeiten keine großen Anforderungen an Arbeitsaufwand und Auslegung.

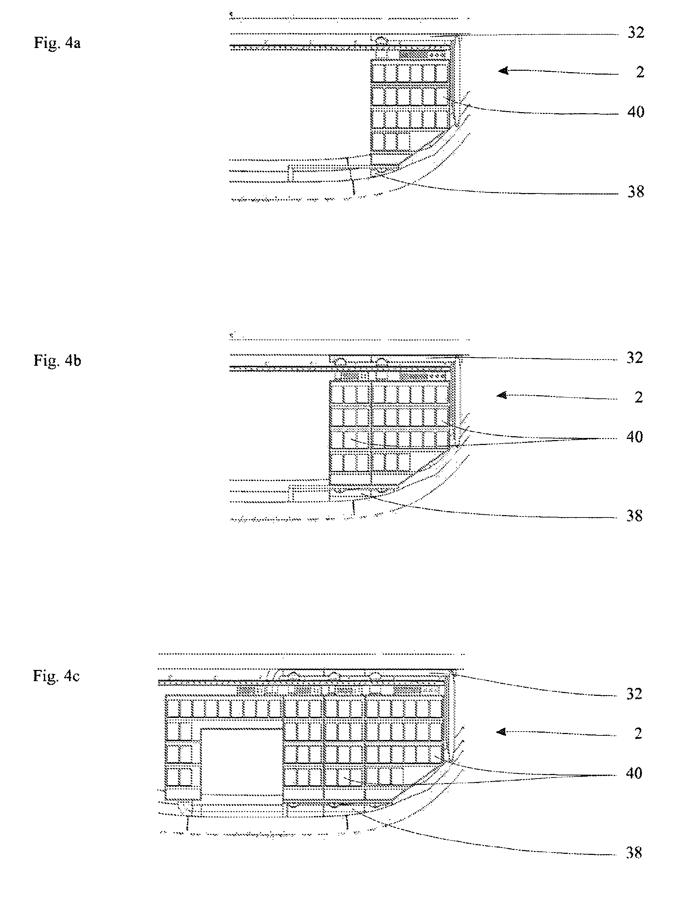

Mögliche Varianten des erfindungsgemäßen Geräteträgers werden in den Figuren 4a bis 4c gezeigt, bei denen eine verschieden große Anzahl von Geräten 40 innerhalb des Geräteträgers 2 angeordnet werden. So zeigt beispielsweise die Fig. 4a den Grundaufbau mit lediglich einem Grundmodul aus einem äußeren Rahmengestell 4 und einem inneren Rahmengestell 6, das sich an den Seiten des Frachtraums des Flugzeugs anschmiegt. In Fig. 4b dient bereits ein Anbaumodul 16 zur Erweiterung des erfindungsgemäßen Geräteträger 2, so dass bereits eine relative große Anzahl von Geräten 40 beherbergt werden kann. Die Kühlluftleitung 32 ist zu diesem Zweck entsprechend verlängert, ebenso die Abluftleitung 38. Ein Extrembeispiel zeigt Fig. 4c, bei dem quasi der Großteil der zur Verfügung stehenden Breite des Frachtraums durch verschiedenartige Anbaumodule 16 eingenommen wird. Dabei zeigt sich, dass sich die Anbaumodule 16 nicht ausschließlich durch eine über die gesamte Höhe des Grundmoduls erstreckende quaderförmige Form auszeichnen, sondern beispielsweise auch nur über einen Teil dieser Höhe, so dass nach Darstellung aus Fig. 4c etwa ein Durchgang bzw. eine Ausnehmung geschaffen werden kann.

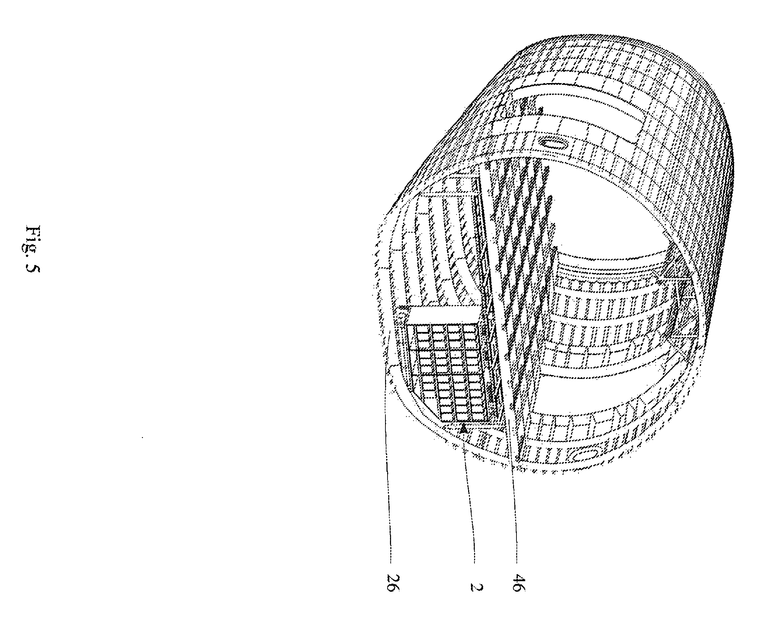

Schließlich wird in Fig. 5 ein bevorzugtes Ausführungsbeispiel zur Beherbergung eines erfindungsgemäßen Geräteträgers in einem Frachtraum eines Flugzeugs plastisch veranschaulicht, bei dem sich der Geräteträger 2 im Wesentlichen von einem Frachtraumfußboden 26 bis zu einem Kabinenfußboden 46 erstreckt.

Durch den erfindungsgemäßen Geräteträger 2 wird eine vorteilhafte Möglichkeit geschaffen, bei der Ausrüstung eines Fahrzeugs besonders individuell auf die Wünsche des Fahrzeugbetreibers eingehen zu können, was die Integration von (elektronischen) Geräten betrifft. Jeder Fahrzeugbetreiber hat seine bestimmten Vorlieben, was die Auswahl an Geräten, dadurch auch deren Abmessungen und Energieverbrauch angeht, so dass im Stand der Technik für jeden Fahrzeugbetreiber eine individuelle Lösung zur Beherbergung dieser Geräte gefunden werden muss. Mit der erfindungsgemäßen Lösung ist es möglich, auf die individuellen Wünsche einzugehen, ohne dass auf eine modulartige Bauweise mit standardisierten Baugruppen verzichtet werden muss. Durch den modulartigen Aufbau entfallen große Anpassarbeiten, der Arbeitsaufwand wird deutlich geringer und eine Anpassung an auszutauschende, zu ergänzende oder zu entfernende Geräte kann ohne großen Aufwand realisiert werden. Der erfindungsgemäße Geräteträger kann auch für sicherheitskritische avionische Geräte verwendet werden, die zur Funktion des Flugzeugs notwendig sind und deren Auswahl im Wesentlichen nicht von den Flugzeugbetreibern getroffen wird.

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

### Bezugszeichen:

- 2: Geräteträger
- 4: äußeres Rahmengestell
- 6: inneres Rahmengestell
- 8: angeschrägte Ecke des äußeren Rahmengestells
- 10: Fachbegrenzungsmittel
- 12: Kühllufteinlass
- 14: Fach für ein Gerät
- 16: Modulanbau
- 18: äußeres Rahmengestell des Modulanbaus
- 20: Kühllufteinlass des Modulanbaus
- 22: inneres Rahmengestell des Modulanbaus
- 24: Träger zum Haltern des Geräteträgers am Frachtraumfußboden
- 26: Frachtraumfußboden
- 28: Kühlluftauslass der Kühlluftleitung
- 30: Kühlluftauslass der Kühlluftleitung
- 32: Kühlluftleitung
- 34: Ablufteinlassöffnung der Abluftleitung
- 36: Ablufteinlassöffnung der Abluftleitung
- 38: Abluftleitung
- 40: Gerät
- 42: inneres Rahmengestell
- 44: Regalreihe
- 46: Kabinenfußboden

## Patentansprüche

1. Modularer Geräteträger (2) zum Haltern von Geräten (40) in einem Fahrzeug, mit mindestens einem ersten äußeren Gestell (4, 18), das an der Struktur des Fahrzeugs lagerbar ist, einen Einbauraum bereitstellt und mindestens eine Schnittstelle (12, 20) zum Versorgen mindestens eines in dem Geräteträger (2) zu halternden Geräts (40) aufweist,
**dadurch gekennzeichnet, dass** das erste äußere Gestell (4, 18) in Modulbauweise mit einem oder mehreren zweiten äußeren Gestellen (4, 18) verbindbar ist,
dass der Geräteträger (2) mindestens ein inneres Gestell (6, 42) aufweist, das Rastmittel und/oder mechanische Anbindungspunkte und/oder Führungen zum variablen Haltern von Fachbegrenzungsmitteln (10) zum Ausbilden mindestens eines Fachs (14) zum Einbringen und Haltern mindestens eines Einsatzes zum Aufnehmen jeweils mindestens eines Geräts (40) aufweist und
dass das äußere Gestell (4, 18) zum Befestigen des mindestens einen inneren Gestells (6, 42) eingerichtet ist.

2. Geräteträger nach Anspruch 1, wobei die Schnittstelle (12, 20) ein Kühlmittelanschluss ist.

3. Geräteträger nach Anspruch 1, wobei die Schnittstelle (12, 20) eine elektrische Schnittstelle ist.

4. Geräteträger (2) nach Anspruch 1, wobei das innere Gestell (6, 42) und/oder das äußere Gestell (4, 18) als Rahmengestell ausgeführt ist.

5. Geräteträger (2) nach einem der vorhergehenden Ansprüche, wobei das äußere Gestell (4, 18) aus einem einen Wabenkern aufweisenden Werkstoff besteht.

6. Geräteträger (2) nach einem der vorhergehenden Ansprüche, wobei das äußere Gestell (4, 18) zum vollständigen Aufnehmen von fahrzeugseitigen und gestellseitigen auf das äußere Gestell (4, 18) wirkenden Lasten ausgelegt ist.

7. Geräteträger (2) nach einem der vorhergehenden Ansprüche, bei dem das innere Gestell (6, 42) in das korrespondierende äußere Gestell (4, 18) einschiebbar ist.

8. Geräteträger (2) nach einem der vorhergehenden Ansprüche, bei dem das innere Gestell (6, 42) aus einem metallischen Werkstoff besteht.

9. Verwendung eines Geräteträgers (2) nach einem der Ansprüche 1-8 in einem Flugzeug.

10. Verwendung nach Anspruch 9, wobei der Geräteträger (2) innerhalb eines Frachtraums angeordnet wird.

11. Flugzeug mit einem Geräteträger (2) nach einem der Ansprüche 1-8.

## Claims

1. A modular equipment carrier (2) for mounting equipment (40) in a vehicle, comprising at least one outer rack (4, 18), which is supportable on the structure of the vehicle, provides a installation space and comprises at least one interface (12, 20) for supplying at least one piece of equipment (40) to be held in the equipment carrier (2),
**characterized in that** the outer rack (4, 18) is connectable to one or more second outer racks (4, 18) in a modular design,
**in that** the equipment carrier (2) comprises at least one inner rack (6, 42), which comprises latching means and/or mechanical connecting points and/or guides for variably mounting compartmentalizing means (10) for forming at least one compartment (14) for inserting and holding at least one tray for accomodating at least one piece of equipment (40) and
**in that** the outer rack (4, 18) is adapted for fastening the at least one inner rack (6, 42).

2. Equipment carrier according to claim 1, wherein the interface (12, 20) is a cooling connection.

3. Equipment carrier according to claim 1, wherein the interface (12, 20) is an electrical interface.

4. The equipment carrier (2) of claim 1, wherein the inner rack (6, 42) and/or the outer rack (4, 18) is realized in the form of a frame rack.

5. The equipment carrier (2) of one of the preceding claims, wherein the outer rack (4, 18) consists of a material with a honeycomb core.

6. The equipment carrier (2) of one of the preceding claims, wherein the outer rack (4, 18) is designed for completely supporting loads of the vehicle and the rack that act upon the outer rack (4, 18).

7. The equipment carrier (2) of one of the preceding claims, wherein the inner rack (6, 22, 42) is insertable into the corresponding outer rack (4, 18).

8. The equipment carrier (2) of one of the preceding claims, wherein the inner rack (6, 22, 42) consists of a metallic material.

9. The use of an equipment carrier (2) of one of claims 1-8 in an aircraft.

10. The use of claim 9, wherein the equipment carrier (2) is arranged within a cargo area.

11. An aircraft with an equipment carrier (2) of one of claims 1-8.

## Revendications

1. Support d'appareils modulaire (2) destiné à maintenir des appareils (40) dans un véhicule, comprenant au moins un premier cadre extérieur (4, 18) qui peut être monté sur la structure du véhicule, offre un espace de montage et présente au moins une interface (12, 20) pour alimenter au moins un appareil (40) qui doit être maintenu dans le support d'appareils (2),
**caractérisé en ce que** le premier cadre extérieur (4, 18) peut être relié à un ou plusieurs seconds cadres extérieurs (4, 18) de manière modulaire,
**en ce que** le support d'appareils (2) présente au moins un cadre intérieur (6, 42) qui présente des moyens d'encliquetage et/ou des points d'attache mécanique et/ou des guidages destinés à maintenir de manière variable des moyens de limitation de compartiments (10) afin de former au moins un compartiment (14) pour introduire et maintenir au moins un plateau de réception respectivement d'au moins un appareil (40) et
**en ce que** le cadre extérieur (4, 18) est agencé pour fixer l'au moins un cadre intérieur (6, 42).

2. Support d'appareils selon la revendication 1, dans lequel l'interface (12, 20) est une liaison en liquide de refroidissement.

3. Support d'appareils selon la revendication 1, dans lequel l'interface (12, 20) est une interface électrique.

4. Support d'appareils (2) selon la revendication 1, dans lequel le cadre intérieur (6, 42) et/ou le cadre extérieur (4, 18) est réalisé sous la forme d'un rack.

5. Support d'appareils (2) selon une des revendications précédentes, dans lequel le cadre extérieur (4, 18) est composé d'une matière présentant un noyau en nid d'abeille.

6. Support d'appareils (2) selon une des revendications précédentes, dans lequel le cadre extérieur (4, 18) est dimensionné pour recevoir entièrement les charges côté véhicule et côté cadre agissant sur le cadre extérieur (4, 18).

7. Support d'appareils (2) selon une des revendications précédentes, dans lequel le cadre intérieur (6, 42) peut être inséré dans le cadre extérieur correspondant (4, 18).

8. Support d'appareils (2) selon une des revendications précédentes, dans lequel le cadre intérieur (6, 42) est composé d'une matière métallique.

9. Utilisation d'un support d'appareils (2) selon une des revendications 1 à 8 dans un avion.

10. Utilisation selon la revendication 9, dans laquelle le support d'appareils (2) est disposé à l'intérieur d'une soute.

11. Avion avec un support d'appareils (2) selon une des revendications 1 à 8.
